# EUROPÄISCHE PATENTSCHRIFT

(11) **EP 0 750 344 B1**
(45) Veröffentlichungstag und Bekanntmachung des Hinweises auf die Patenterteilung: **18.07.2007**
(21) Anmeldenummer: 96108534.7
(22) Anmeldetag: 29.05.1996
(51) Int. Cl.: H01L 25/065, H01L 25/07, H01L 23/495

(54) **Leistungs-Halbleitermodul mit Anschlussstiften**
Semiconductor power module with connection pins
Module semi-conducteur de puissance avec des broches de connexion

(30) Priorität: 19.06.1995 DE 19522172
(43) Veröffentlichungstag der Anmeldung: 27.12.1996
(73) Patentinhaber: Infineon Technologies AG, 81669 München (DE)
(72) Erfinder: Miller, Gerhard, Dr. Ing., 86929 Penzing (DE); Feldvoss, Mario, Dipl.- Ing., 80689 München (DE)
(74) Vertreter: Bickel, Michael

(56) Entgegenhaltungen:
- EP-A- 0 546 731
- DE-A- 3 516 995
- DE-A- 4 325 942
- DE-U- 9 203 000
- US-A- 4 885 629
- PATENT ABSTRACTS OF JAPAN vol. 015, no. 165 (E-1061), 25. April 1991 & JP 03 034561 A (MITSUBISHI ELECTRIC CORP), 14. Februar 1991
- "Kleine Chips mit grosser Wirkung" TECHNISCHE RUNDSCHAU., Bd. 73, Nr. 52/53, 29. Dezember 1981, Seiten 10-11, XP002094180 BERN CH
- TETSUJIRO TSUNODA ET AL: "LOW-INDUCTANCE MODULE CONSTRUCTION FOR HIGH SPEED, HIGH CURRENT IGBT MODULE SUITABLE FOR ELECTRIC VEHICLE APPLICATION" PROCEEDINGS OF THE INTERNATIONAL SYMPOSIUM ON POWER SEMICONDUCTOR DEVICES AND IC'S (ISPSD), MONTEREY, MAY 18 - 20, 1993, Nr. SYMP. 5, 18. Mai 1993, Seiten 292-295, XP000380163 WILLIAMS R K;JAYANT BALIGA B
- PATENT ABSTRACTS OF JAPAN vol. 008, no. 243 (E-277), 8. November 1984 & JP 59 121860 A (TOSHIBA KK), 14. Juli 1984

## Beschreibung

Die Erfindung bezieht sich auf ein Leistungs-Halbleitermodul mit den Merkmalen:
- einem Gehäuse mit einer Gehäusewand,
- einem Boden, auf dem eine Vielzahl von Halbleiterkörpern befestigt ist,
- im Inneren der Gehäusewand sind Anschlußleiter angeordnet, die jeweils einen oberen aus der Gehäusewand ragenden Teil haben,
- die Anschlußleiter haben einen unteren Teil, der innen aus der Gehäusewand ragt,
- der obere Teil der Anschlußleiter ist als Anschlußstift ausgebildet,
- der untere Teil ist elektrisch mit den Halbleiterkörpern verbunden.

Solche Leistungs-Halbleitermodule sind auf dem Markt. Sie werden z.B. im "SIPMOS-Katalog" 1993/94, Seite 35 angeboten. Durch die Stifte der Anschlußleiter ist eine Verbindung des Leistungs-Halbleitermoduls mit Schaltungsplatinen durch Schwallöten möglich. Das bekannte Leistungs-Halbleitermodul ist so aufgebaut, daß jeder Anschlußleiter in einem einzigen Stift endet.

Mit größeren Strömen reicht die Stromtragfähigkeit solcher Anschlußleiter nicht mehr aus, um den Laststrom zu führen. Man muß daher zu Anschlußleitern mit größerem Querschnitt übergehen. Es ist jedoch nicht ohne weiteres möglich, solche größeren Anschlußleiter mit Schaltungsplatinen durch Schwallöten zu verbinden. Außerdem genügt nicht mehr ein einfaches Lochen der Platine, sondern es müssen Schlitze entsprechend dem Querschnitt des Anschlußleiters gestanzt werden. Darüber hinaus haben Versuche, Anschlußleiter größeren Querschnitts mit der Schaltungsplatine durch Schwallöten zu verbinden, gezeigt, daß die Lotstelle stark inhomogen war. Dies führte dazu, daß die Stromtragfähigkeit des Anschlußleiters nicht ausgenutzt werden konnte.

Die JP 03/034561 A beschreibt ein Halbleitermodul mit einem innerhalb eines Gehäuses angeordneten Halbleiterchip, der mittels Bonddrähten innerhalb des Gehäuses an Anschlussleiter angeschlossen ist. Das Gehäuse weist eine Gehäusewand auf, aus der die Anschlussleiter an einem oberen Ende herausragen, um beispielsweise auf einer Platine montiert zu werden.

Aus "Kleine Chips mit großer Wirkung", technische Rundschau, Bd 73, Nr. 52/53, 29. Dezember 1981, Seiten 10 - 11, Bild 15, ist eine MOSFET-Bauelementanordnung bekannt, bei der ein Leadframe, auf dem jeweils ein MOSFET-Chip angeordnet ist, aus dem Gehäuse herausragt. Dieser plattenförmige Leadframe verzweigt sich außerhalb des Gehäuses auf zwei Anschlussbeine.

Der Erfindung liegt die Aufgabe zugrunde, ein Leistungs-Halbleitermodul zur Verfügung zu stellen, das Anschlussleiter mit einer großen Stromtragfähigkeit aufweist, die auf einfache Weise mit einer Platine verlötet werden können.

Diese Aufgabe wird gelöst durch die charakterisiereden Merkmale von Anspruch 1:
a) Der obere Teil jedes Leiters besteht aus mindestens zwei Stiften, wobei ausschließlich die Stifte aus der Wand herausragen.
b) die Anschlußleiter sind innerhalb der Wand und im unteren Teil rechteckig ausgebildet und haben einen größen Querschnitt als die Summe der Querschnitte der Stifte.

Es hat sich in überraschender Weise gezeigt, daß die Stromtragfähigkeit einer solchen Anordnung besser ist als die Stromtragfähigkeit einer Anordnung, bei der die Anschlußleiter mit ihrem rechteckigen Querschnitt mit der Platine verlötet wurden.

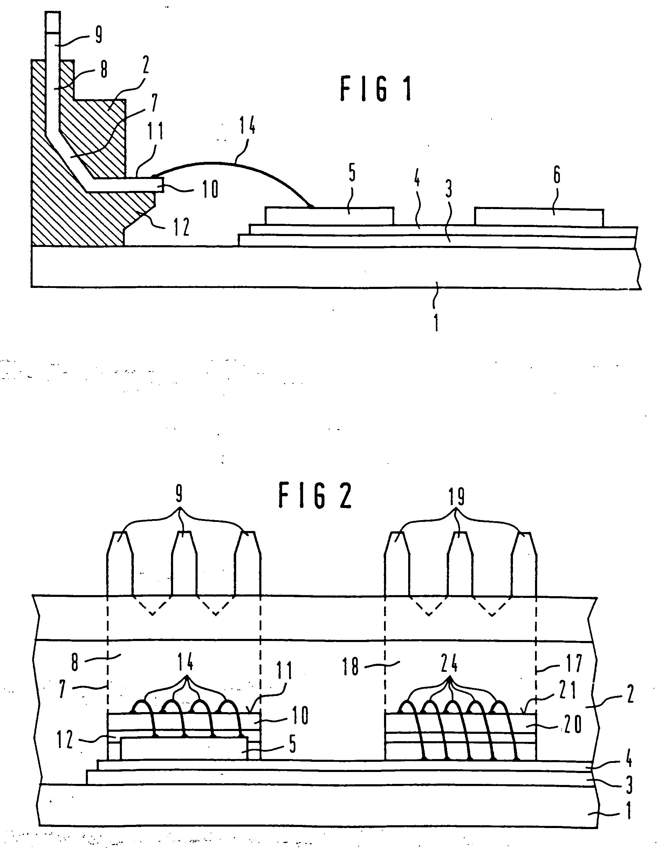

Weiterbildungen der Erfindung sind Gegenstand der Unteransprüche. Die Erfindung wird anhand eines Ausführungsbeispiels in Verbindung mit den Figuren 1 und 2 näher erläutert. Es zeigen
- Figur 1: eine schematische erste Seitenansicht eines Leistungs-Halbleitermoduls nach Erfindung und
- Figur 2: eine schematische zweite Seitenansicht des Leistungs-Halbleitermoduls.

Das Leistungs-Halbleitermodul hat einen Metallboden 1, der mit einem aus Isolierstoff bestehenden Gehäuse verbunden ist. Vom Gehäuse ist nur eine Wand 2 im Schnitt gezeigt. Auf dem Metallboden sitzt ein Keramiksubstrat 3, auf dem Leiterbahnen aufgebracht sind. Eine dieser Leiterbahnen ist dargestellt und mit 4 bezeichnet. Darauf sind Halbleiterkörper 5 und 6 befestigt.

Das Halbleitermodul hat Anschlußleiter 7, deren mittlerer Teil 8 allseitig von der Wand 2 umschlossen ist. Der obere Teil 9 ragt aus der Oberseite der Wand heraus. Der untere Teil 10 ragt aus der Innenseite der Wand heraus. Der untere Teil 10 bildet eine Bondfläche 11, die vorzugsweise parallel zur Oberfläche der Halbleiterkörper 5, 6 liegt. Zur Erhöhung der mechanischen Stabilität kann der untere Teil 10 des Anschlußleiters 7 von einem Podest 12 unterstützt werden. Dieses Podest kann Teil der Gehäusewand sein und dient dazu, den Druck des Bonders auf die Bondfläche 11 aufzunehmen. Die Bondfläche 11 ist mit dem Halbleiterkörper 5 durch Bonddrähte 14 verbunden, von denen hier der besseren Übersichtlichkeit halber nur ein einziger dargestellt ist.

Der obere Teil 9 des Anschlußleiters 7 trägt mindestens zwei Stifte, die dazu bestimmmt sind, in Bohrungen einer Schaltungsplatine einzugreifen. Die Summe der Querschnitte dieser Stifte ist dabei kleiner als der Querschnitt des Anschlußleiters 7 im mittleren Teil 8 und im unteren Teil 10.

In Figur 2 ist insbesondere die Form der Anschlußleiter mit den Stiften dargestellt. In diesem Fall hat der Anschlußleiter drei Stifte 9, die aus der Oberseite der Wand 2 herausragen. Die Stifte 9 sind z.B. 1,5 mm breit und 1 mm dick. Ihr Mittenabstand entspricht vorzugsweise einem Rastermaß von 3,83 mm. Der Mittelteil 8 des Anschlußleiters 7 befindet sich gänzlich in der Wand 2. Es ragen also ausschließlich die Stifte 9 aus der Wand heraus und unten die Bondflächen 11. Im übrigen sind entsprechende Teile mit den gleichen Bezugszeichen wie in Figur 1 versehen. Für höhere Ströme kann der Anschlußleiter auch mehr als drei Stifte aufweisen.

Entsprechend der hohen Stromtragfähigkeit des Anschlußleiters 7 und der Stifte 9 wird der Halbleiterkörper 5 über eine Vielzahl von z.B. 10 bis 20 Bonddrähten 14 mit dem Anschlußleiter 7 verbunden.

Die Unterseite des Halbleiterkörpers 5 ist über die Leiterbahn 4 mit Hilfe von Bonddrähten 24 mit einem Anschlußleiter 17 kontaktiert, der in seiner Form dem Anschlußleiter 7 entspricht. Der Anschlußleiter 17 hat wieder ein Mittelteil 18, das vollständig in der Wand 2 angeordnet ist. Der Oberteil des Anschlußleiters 17 hat die Form von drei Stiften 19, sein Unterteil 20 liegt wieder parallel zur Oberfläche der Halbleiterkörper und ist mit einer Bondfläche 21 versehen. Die Bondfläche 21 ist über eine Vielzahl, z.B. 10 bis 20 Bonddrähte 24 mit der Leiterbahn 4 elektrisch verbunden.

Die Stifte lassen sich auf einfachere Weise durch Ausstanzen aus den Anschlußleitern erzeugen.

Mit einem Leistungs-Halbleitermodul der beschriebenen Art lassen sich Halbbrücken, Vollbrücken, Dreiphasenbrücken usw. erzeugen. Für eine Dreiphasenbrücke sind dann fünf Anschlußleiter 9, 19 erforderlich für die einzelnen Wechselstromphasen und für die Gleichstromanschlüsse. Für andere Schaltungen ist eine entsprechende Anzahl von Anschlußleitern vorgesehen.

## Patentansprüche

1. Leistungs-Halbleitermodul mit den Merkmalen:
- einem Gehäuse mit einer Gehäusewand (2),
- einem Boden (1), auf dem eine Vielzahl von Halbleiterkörpern (5, 6) befestigt ist,
- im Inneren der Gehäusewand (2) sind Anschlußleiter (7) angeordnet, die jeweils einen oberen aus der Gehäusewand ragenden Teil (9) haben,
- die Anschlußleiter haben einen unteren Teil (10), der innen aus der Gehäusewand (2) ragt,
- der obere Teil der Anschlußleiter (7) ist als Anschlußstift ausgebildet,
- der untere Teil ist elektrisch mit dem Halbleiterkörper verbunden,
**gekennzeichnet durch** die Merkmale:
a) der obere Teil (9) jedes Leiters (7) besteht aus mindestens zwei Stiften, wobei ausschließlich die Stifte aus der Wand (2) heraus ragen.
b) die Anschlußleiter (7) sind innerhalb der Wand (2) und im unteren Teil im Querschnitt rechteckig ausgebildet und haben eine größere Querschnittsfläche als die Summe der Querschnitte der Stifte.

2. Leistungs-Halbleitermodul nach Anspruch 1,
**dadurch gekennzeichnet, daß** die Stifte jedes Leiters (7, 17) einen Abstand voneinander haben, der einem vorgegebenen Rastermaß entspricht.

3. Leistungs-Halbleitermodul nach Anspruch 1 oder 2,
**dadurch gekennzeichnet, daß** der untere Teil (10) der Anschlußleiter (7, 17) eine zur Oberfläche der Halbleiterkörper parallel liegende Bondfläche (11, 21) hat.

4. Leistungs-Halbleitermodul nach einem der Ansprüche 1 bis 3,
**dadurch gekennzeichnet, daß** mindestens einer der Anschlußleiter über eine Vielzahl von parallelen Bonddrähten (14) mit mindestens einem der Halbleiterkörper (5, 6) verbunden ist.

5. Leistungs-Halbleitermodul nach einem der Ansprüche 1 bis 3,
**dadurch gekennzeichnet, daß** die Halbleiterkörper (5, 6) auf einem Leiterbahnen (4) tragenden Keramiksubstrat (3) angeordnet und mit diesem elektrisch verbunden sind, und daß die Bondfläche (11, 21) mindestens einer der Anschlußleiter (7, 17) über eine Vielzahl von parallelen Bonddrähten (24) mit einer der Leiterbahnen verbunden ist.

6. Leistungs-Halbleitermodul nach einem der Ansprüche 1 bis 5,
**dadurch gekennzeichnet, daß** unter den Bondflächen Podeste (12) angeordnet sind, die Teil der Gehäusewand (2) sind.

7. Leistungs-Halbleitermodul nach einem der Ansprüche 1 bis 6,
**dadurch gekennzeichnet, daß** die Stifte (9) die gleiche Dicke wie der in der Wand (2) liegende Teil (8) der Anschlußleiter (7) haben.

8. Leistungs-Halbleitermodul nach einem der Ansprüche 1 bis 7,
**dadurch gekennzeichnet, daß** die Stifte (9) aus dem Anschlußleiter ausgestanzt sind.

9. Leistungs-Halbleitermodul nach Anspruch 2,
**dadurch gekennzeichnet, daß** das Rastermaß 3,83 mm ist.

## Claims

1. Semiconductor power module comprising:
- a housing having a housing wall (2),
- a base (1) to which a multiplicity of semiconductor bodies (5, 6) are fastened,
- connection conductors (7) each having an upper part (9) that projects from the housing wall are arranged inside the housing wall (2),
- the connection conductors have a lower part (10) which projects from the inside of the housing wall (2),
- the upper part of the connection conductors (7) is in the form of a connection pin,
- the lower part is electrically connected to the semiconductor body,
**characterized by** the following features:
a) the upper part (9) of each conductor (7) comprises at least two pins, only the pins projecting from the wall (2),
b) the connection conductors (7) have a rectangular cross section inside the wall (2) and in the lower part and have a larger cross-sectional area than the sum of the cross sections of the pins.

2. Semiconductor power module according to Claim 1, **characterized in that** the pins of each conductor (7, 17) are at a distance from one another corresponding to a prescribed grid dimension.

3. Semiconductor power module according to Claim 1 or 2,
**characterized in that** the lower part (10) of the connection conductors (7, 17) has a bonding area (11, 21) which is parallel to the surface of the semiconductor bodies. which is parallel to the surface of the semiconductor bodies.

4. Semiconductor power module according to one of Claims 1 to 3,
**characterized in that** at least one of the connection conductors is connected to at least one of the semiconductor bodies (5, 6) via a multiplicity of parallel bonding wires (14).

5. Semiconductor power module according to one of Claims 1 to 3,
**characterized in that** the semiconductor bodies (5, 6) are arranged on, and are electrically connected to, a ceramic substrate (3) which has conductor tracks (4), and **in that** the bonding area (11, 21) of at least one of the connection conductors (7, 17) is connected to one of the conductor tracks via a multiplicity of parallel bonding wires (24).

6. Semiconductor power module according to one of Claims 1 to 5,
**characterized in that** platforms (12) which are part of the housing wall (2) are arranged under the bonding areas.

7. Semiconductor power module according to one of Claims 1 to 6,
**characterized in that** the pins (9) have the same thickness as that part (8) of the connection conductors (7) which is in the wall (2).

8. Semiconductor power module according to one of Claims 1 to 7,
**characterized in that** the pins (9) are punched out of the connection conductor.

9. Semiconductor power module according to Claim 2, **characterized in that** the grid dimension is 3.83 mm.

## Revendications

1. Module semi-conducteur de puissance qui comprend :
- un boîtier muni d'une paroi (2),
- un fond (1) sur lequel sont fixés un grand nombre de semi-conducteurs (5, 6),
- des conducteurs de branchement (7) dans la paroi (2) du boîtier ayant chacun une partie (9) qui dépasse du dessus de la paroi du boîtier,
les conducteurs de branchement (7) ont une partie inférieure (10) qui dépasse du côté intérieur de la paroi (2) du boîtier,
la partie supérieure des conducteurs de branchement (7) est réalisée sous la forme d'une broche de branchement,
la partie inférieure est reliée électriquement au semi-conducteur,
**caractérisé en ce que**
a) la partie supérieure (9) de chaque conducteur (7) se compose d'au moins deux broches qui sont seules à dépasser de la paroi (2),
b) les conducteurs de branchement (7) ont une section rectangulaire dans la paroi (2) et dans la partie inférieure et la surface de leur section est plus grande que la somme des sections des broches.

2. Module semi-conducteur de puissance selon la revendication 1,
**caractérisé en ce que**
les broches de chaque conducteur (7, 17) sont écartées d'une distance correspondant à une trame prédéfinie.

3. Module semi-conducteur de puissance selon la revendication 1 ou 2,
**caractérisé en ce que**
la partie inférieure (10) des conducteurs de branchement (7, 17) présente une surface de liaison (11, 21) parallèle à la surface du semi-conducteur.

4. Module semi-conducteur de puissance selon l'une des revendications 1 à 3,
**caractérisé en ce qu'**
au moins l'un des conducteurs de branchement est relié par un grand nombre de fils de liaison (14), parallèles, à au moins l'un des semi-conducteurs (5, 6).

5. Module semi-conducteur de puissance selon l'une des revendications 1 à 3,
**caractérisé en ce que**
les semi-conducteurs (5, 6) sont installés sur un substrat en céramique (3) portant les chemins conducteurs (4) en étant reliés électriquement à celui-ci, et
les surfaces de liaison (11, 21) d'au moins un conducteur de branchement (16, 17) sont reliées à l'un des chemins conducteurs par un grand nombre de fils de liaison parallèles (24).

6. Module semi-conducteur de puissance selon l'une des revendications 1 à 5,
**caractérisé en ce que**
les socles (12) sont prévus sous les surfaces de liaison, ces socles faisant partie de la paroi (2) du boîtier.

7. Module semi-conducteur de puissance selon l'une des revendications 1 à 6,
**caractérisé en ce que**
les broches (9) ont la même épaisseur que la partie (8) des conducteurs de branchement (7) intégrés dans la paroi (2).

8. Module semi-conducteur de puissance selon l'une des revendications 1 à 7,
**caractérisé en ce que**
les broches (9) sont découpées dans le conducteur de branchement.

9. Module semi-conducteur de puissance selon la revendication 2,
**caractérisé en ce que**
la trame correspond à 3,83 mm.
